# EUROPEAN PATENT APPLICATION

(11) **EP 4 546 761 A1**
(43) Date of publication of application: **30.04.2025**
(21) Application number: 23855012.3
(22) Date of filing: 20.06.2023
(51) Int. Cl.: H04M 1/02, H05K 1/14, G06F 1/16

(54) **ELECTRONIC DEVICE COMPRISING FIXING MEMBER**

(30) Priority: 18.08.2022 KR 20220103168; 08.09.2022 KR 20220113945
(71) Applicant: Samsung Electronics Co., Ltd., Suwon-si, Gyeonggi-do 16677 (KR)
(72) Inventor: LEE, Seunghoon, Suwon-si, Gyeonggi-do 16677 (KR); KIM, Yunsup, Suwon-si, Gyeonggi-do 16677 (KR); AN, Sanghoon, Suwon-si, Gyeonggi-do 16677 (KR)
(74) Representative: Appleyard Lees IP LLP
(86) International application number: PCT/KR2023/008545
(87) International publication number: WO 2024/039041

(57) **Abstract**

An electronic device, according to one embodiment of the present disclosure, may comprise: a first support member having a flat plate shape; a first circuit board disposed on one surface of the first support member; a fixing member disposed on the first support member at a position adjacent to the first circuit board and including a slit extending in one direction; and a flexible printed circuit board (FPCB) disposed at least partially in an S-shape or zigzag shape through the slit, and having one end connected to the first circuit board. **In** one embodiment, the fixing member may be configured to maintain the position or shape of one end of the flexible printed circuit board relative to the first circuit board by supporting the flexible printed circuit board. Various other embodiments may be possible.

## Description

### [Technical Field]

Embodiments of the disclosure relate to an electronic device, for example, an electronic device including a fixing member.

### [Background Art]

With the development of electronic, information, or communication technology, various functions are being included in a single electronic device. For example, a smartphone may include functions of a sound playback device, an imaging device, or a digital diary, in addition to a communication function, and more diverse functions may be implemented in a smartphone through installation of additional applications. An electronic device may be provided with various pieces of information in real time by accessing a server or another electronic device in a wired or wireless manner as well as by executing an installed application or a stored file.

As the performance of electronic devices has been enhanced and the electronic devices have been downsized, and it has become possible for users to carry and use electronic devices on a daily basis. The development of information and communication technology makes it convenient to carry and use electronic devices by increasing the degree of integration of electronic devices. As the degree of integration of electronic devices increases, a stable operating environment may be provided by protecting internal components from external causes (e.g., impacts caused by changes in temperature and humidity or dropping) in the arrangement of various components inside electronic devices.

The above information may be provided as background art for the purpose of assisting in an understanding of the disclosure. None of the above contents make an assertion or decision as to whether any of the above might be applicable as prior art with regard to the disclosure.

### [Detailed Description of the Invention]

### [Technical Solution]

According to an embodiment of the disclosure, an electronic device may include a first support member having a flat shape, a first circuit board disposed on one surface of the first support member, a fixing member disposed on the first support member at a position adjacent to the first circuit board and including a slit extending in one direction, and a flexible printed circuit board (FPCB) disposed at least partially in an S shape or a zigzag shape through the slit and having one end portion connected to the first circuit board. In an embodiment, the fixing member may be configured to support the flexible printed circuit board to maintain a position or shape of the one end portion of the flexible printed circuit board relative to the first circuit board.

According to an embodiment, an electronic device may include a first support member having a flat shape, a first circuit board disposed at a first position on an one surface of the first support member, a second circuit board disposed at a second position different from the first position on the one surface of the first support member, a fixing member disposed on the first support member at a position adjacent to the first circuit board and including a slit extending in one direction, and a flexible printed circuit board disposed at least partially in an S shape or a zigzag shape through the slit, the flexible printed circuit board being connected at one end portion to the first circuit board and electrically connecting the second circuit board to the first circuit board. In an embodiment, the fixing member may include a first rod disposed across the flexible printed circuit board to guide the flexible printed circuit board and thereby maintain a position or shape of the one end portion of the flexible printed circuit board relative to the first circuit board, and a second rod disposed across the flexible printed circuit board at a position farther from the first circuit board or the first support member than the first rod. In an embodiment, the slit may be formed between the first rod and the second rod.

### [Brief Description of Drawings]

The above and other aspects, features, and/or advantages of an embodiment of the disclosure will be more apparent from the following detailed description taken with reference to the accompanying drawings.
FIG. 1 is a front perspective view of an electronic device according to an embodiment of the disclosure.
FIG. 2 is a perspective view illustrating the electronic device of FIG. 1 according to an embodiment of the disclosure, viewed from the rear side.
FIG. 3 is an exploded perspective view illustrating the electronic device of FIG. 1 according to an embodiment of the disclosure, viewed from the front side.
FIG. 4 is a rear exploded perspective view illustrating the electronic device according to an embodiment of the disclosure illustrated in FIG. 1.
FIG. 5 is a perspective view illustrating a state after a fixing member and/or a flexible printed circuit board has been placed in an electronic device according to an embodiment of the disclosure.
FIG. 6 is a perspective view illustrating a state after the fixing member and/or the flexible printed circuit board is being placed in the electronic device according to an embodiment of the disclosure.
FIG. 7 is a perspective view illustrating a state while the fixing member is being placed on a flexible printed circuit board in an electronic device according to an embodiment of the disclosure.
FIG. 8 is a perspective view illustrating a state after the fixing member has been placed on the flexible printed circuit board in the electronic device according to an embodiment of the disclosure.
FIG. 9 is a view illustrating a state after a fixing member and/or a flexible printed circuit board has been placed in an electronic device according to an embodiment of the disclosure.
FIG. 10 is a view illustrating a partial cross-sectional view of the electronic device according to an embodiment of the disclosure taken along line A-A of FIG. 9.
FIG. 11 is a view illustrating a partial cross-sectional view of the electronic device according to an embodiment of the disclosure taken along line B-B of FIG. 9.
FIG. 12 is a view illustrating a partial cross-sectional view of the electronic device taken along line B-B in FIG. 9, according to an embodiment of the disclosure, in which a deformed state of a portion of the fixing member and/or the flexible printed circuit board is illustrated.
FIG. 13 is a view illustrating a flexible printed circuit board of an electronic device according to an embodiment of the disclosure.

Throughout the appended drawings, like reference numerals may be assigned to like components, configurations, and/or structures.

### [Mode for Carrying out the Invention]

As the integration of electronic devices increases, tolerance management may become stricter in the production or arrangement of internal components. For example, when components are arranged in a narrow internal space, a stable operating environment may be provided by ensuring that the sizes or arrangement intervals of the components are within design ranges. However, as tolerance management becomes stricter, there is a possibility that internal components may detach or be damaged due to external factors such as changes in temperature or humidity, or impacts from drops. For example, components such as flexible printed circuit boards or various cables may easily change shape or move due to external forces, and the deformation or movement of flexible printed circuit boards or various cables may be difficult to be easily predicted. For example, such deformation or movement may damage a connecting/binding structure (e.g., a connector(s)) or cause a connected/bound portion to detach.

An embodiment of the disclosure was made to at least address the above-mentioned problems and/or shortcomings and to provide the advantages described below, and may provide an electronic device including a fixing member that standardizes and arranges or fixes a component that is easily deformable in shape.

An embodiment of the disclosure may provide an electronic device including a fixing member capable of maintaining a stable connection state by standardizing a connected or bound portion of a component, such as a flexible printed circuit board.

An embodiment of the disclosure may provide an electronic device including a fixing member capable of suppressing the separation or damage to a connection or binding structure of a component such as a flexible printed circuit board, even when an external force is applied.

The technical subjects pursued in the disclosure may not be limited to the above-mentioned technical subjects, and other technical subjects which are not mentioned may be clearly understood from the following descriptions by those skilled in the art to which the disclosure pertains.

The following description made with reference to the accompanying drawings may provide an understanding of various exemplary implementations of the disclosure including the claims and equivalents thereof. An exemplary embodiment set forth in the following description includes various particular details to help the understanding, but is considered one of various exemplary embodiments. Therefore, it will be apparent to those skilled in the art that various changes and modifications may be made to various implementations described herein without departing from the scope and technical idea of the disclosure. **In** addition, descriptions of well-known functions and configurations may be omitted for clarity and brevity.

The terms and words used in the following description and claims are not limited to bibliographical meanings, but may be used to clearly and consistently describe the various embodiments set forth herein. Therefore, it will be apparent to those skilled in the art that the following description of various implementations of the disclosure is provided only for the purpose of explanation, rather than for the purpose of limiting the disclosure defined as the scope of protection and equivalents thereto.

It should be appreciated that a singular form such as "a," "an," or "the" also includes the meaning as a plural form, unless the context clearly indicates otherwise. Therefore, for example, "a component surface" may mean one or more of component surfaces.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

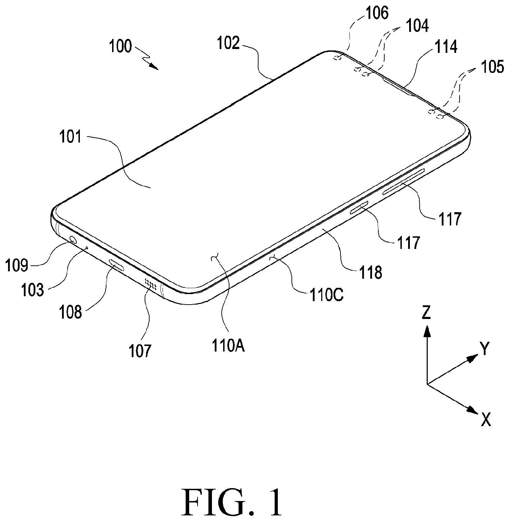

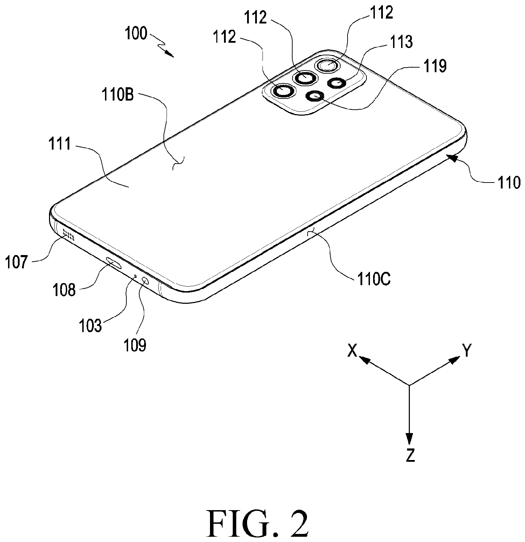

FIG. 1 is a front perspective view of an electronic device 100 according to an embodiment of the disclosure. FIG. 2 is a perspective view illustrating the electronic device 100 of FIG. 1 according to an embodiment of the disclosure, viewed from the rear side.

Referring to FIGS. 1 and 2, the electronic device 100 according to an embodiment may include a housing 110 including a first surface (or a front surface) 110A, a second surface (or a rear surface) 110B, and a side surface 110C surrounding the space between the first surface 110A and the second surface 110B. In an embodiment (not illustrated), the housing 110 may refer to a structure that forms a portion of the first surface 110A of FIG. 1, and the second surface 110B and the side surface 110C of FIG. 2. According to an embodiment, at least a portion of the first surface 110A may be made of a substantially transparent front surface plate 102 (e.g., a glass plate or a polymer plate including various coating layers). The second surface 110B may be made of a substantially opaque rear surface plate 111. The rear surface plate 111 may be made of, for example, coated or colored glass, ceramic, polymer, metal (e.g., aluminum, stainless steel (STS), or magnesium), or a combination of two or more of these materials. The side surface 110C may be defined by the side surface structure (or a "side surface bezel structure") 118 coupled to the front surface plate 102 and the rear surface plate 111 and including metal and/or polymer. In an embodiment, the rear surface plate 111 and the side surface structure 118 may be integrated with each other and may include the same material (e.g., a metal material such as aluminum).

Although not illustrated, the front surface plate 102 may include one or more areas that are curved and extend seamlessly from at least a portion of an edge toward the rear surface plate 111. In an embodiment, the front surface plate 102 (or the rear surface plate 111) may include only one of the areas bent and extending toward the rear surface plate 111 (or the front surface plate 102), at one side edge of the first surface 110A. According to an embodiment, the front surface plate 102 or the rear surface plate 111 may have a substantially flat plate shape, and in this case, may not include a bent and extending area. When the bent and extending area is included, the thickness of the electronic device 100 in the portion including the bent and extending area may be smaller than the thicknesses of other portions.

According to an embodiment, the electronic device 100 may include at least one of a display 101, audio modules 103, 107, and 114, sensor modules 104 and 119, camera modules 105, 112, and 113, key input devices 117, light-emitting elements 106, and connector holes 108 and 109. In an embodiment, in the electronic device 100, at least one of the components (e.g., the key input devices 117 or the light-emitting element 106) may be omitted, or other components may be additionally included.

The display 101 may be visually exposed through a substantial portion of, for example, the front surface plate 102. In an embodiment, at least a portion of the display 101 may be visually exposed through the front surface plate 102 forming the first surface 110A or through a portion of the side surface 110C. In an embodiment, the edge of the display 101 may be formed to be substantially the same as the shape of the periphery of the front surface plate 102 adjacent thereto. In an embodiment (not illustrated), the distance between the periphery of the display 101 and the periphery of the front surface plate 102 may be substantially constant in order to enlarge the visually exposed area of the display 101.

In an embodiment (not illustrated), recesses or openings may be provided in some portions of the screen display area of the display 101, and one or more of the audio module 114, the sensor module 104, the camera module 105, and the light-emitting elements 106 may be aligned with the recesses or the openings. In an embodiment (not illustrated), the rear surface of the screen display area of the display 101 may include at least one of the audio module 114, the sensor modules 104, the camera modules 105, a fingerprint sensor (not illustrated), and the light-emitting elements 106. In an embodiment (not illustrated), the display 101 may be coupled to or disposed adjacent to a touch-sensitive circuit, a pressure sensor capable of measuring a touch intensity (pressure), and/or a digitizer configured to detect an electromagnetic field-type stylus pen. In an embodiment, at least some of the sensor modules 104 and 119 and/or at least some of the key input devices 117 may be disposed in the first areas 110D and/or the second areas 110E.

The audio modules 103, 107, and 114 may include a microphone hole 103 and speaker holes 107 and 114. A microphone configured to acquire external sound may be placed inside the microphone hole 103, and in an embodiment, a plurality of microphones may be placed to detect the direction of sound. The speaker holes 107 and 114 may include an external speaker hole 107 and a communication receiver hole 114. In an embodiment, the speaker holes 107 and 114 and the microphone hole 103 may be implemented as a single hole, or a speaker (e.g., a piezo speaker) may be included without the speaker holes 107 and 114.

The sensor modules 104 and 119 may generate electrical signals or data values corresponding to an internal operating state or an external environmental state of the electronic device 100. The sensor modules 104 and 119 may include, for example, a first sensor module 104 (e.g., a proximity sensor) and/or a second sensor module (not illustrated) (e.g., a fingerprint sensor) disposed on the first surface 110A of the housing 110, and/or a third sensor module 119 and/or a fourth sensor module (e.g., a fingerprint sensor) disposed on the second surface 110B of the housing 110. The fingerprint sensor may be disposed not only on the first surface 110A (e.g., the display 101) of the housing 110, but also on the second surface 110B or the side surface 110C of the housing 110. The electronic device 100 may further include at least one of, for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor 104.

The camera modules 105, 112, and 113 may include a first camera device 105 disposed on the first surface 110A of the electronic device 100, and a second camera device 112 and/or a flash 113 disposed on the second surface 110B. The camera devices 105 and 112 may include one or more lenses, an image sensor, and/or an image signal processor. The flash 113 may include, for example, a light-emitting diode or a xenon lamp. In an embodiment, one or more lenses (e.g., an infrared camera lens, a wide-angle lens, and a telephoto lens) and image sensors may be disposed on one surface of the electronic device 100. In an embodiment, the flash 113 may emit infrared rays, and the infrared light emitted by the flash 113 and reflected by a subject may be received through the third sensor module 119. The electronic device 100 or the processor of the electronic device 100 may detect depth information of the subject based on a time point when infrared rays are received from the third sensor module 119.

The key input devices 117 may be disposed on the side surface 110C of the housing 110. In an embodiment, the electronic device 100 may not include some or all of the above-mentioned key input devices 117, and key input devices 117, which are not included, may be implemented in another form, such as soft keys, on the display 101. In an embodiment, the key input devices may include a sensor module disposed on the second surface 110B of the housing 110.

The light-emitting element 106 may be disposed on, for example, the first surface 110A of the housing 110. The light-emitting element 106 may provide, for example, the state information of the electronic device 100 in an optical form. In an embodiment, the light-emitting element 106 may provide, for example, a light source that is linked with the operation of the camera module 105. The light-emitting element 106 may include, for example, an LED, an IR LED, and a xenon lamp.

The connector holes 108 and 109 may include a first connector hole 108 capable of accommodating a connector (e.g., a USB connector) configured to transmit/receive power and/or data to/from an external electronic device, and/or a second connector hole (e.g., an earphone jack) 109 capable of accommodating a connector configured to transmit/receive an audio signal to/from an external electronic device.

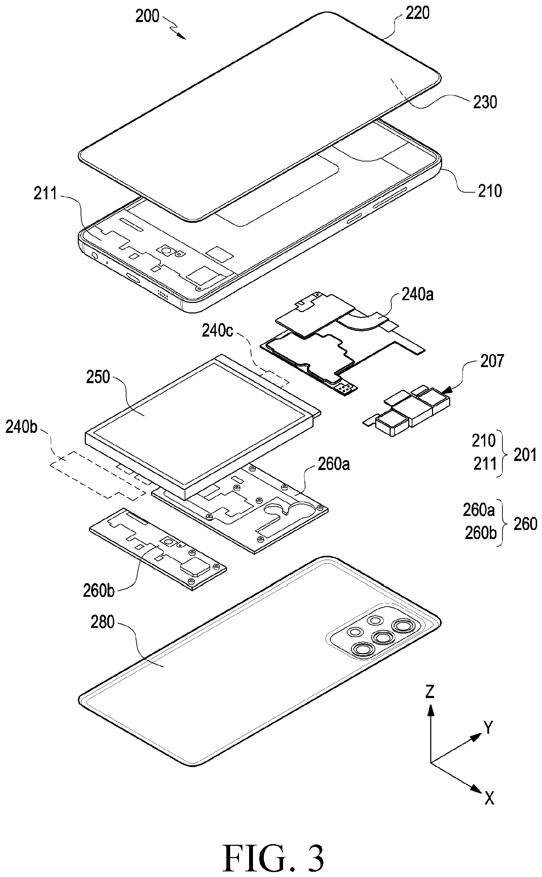

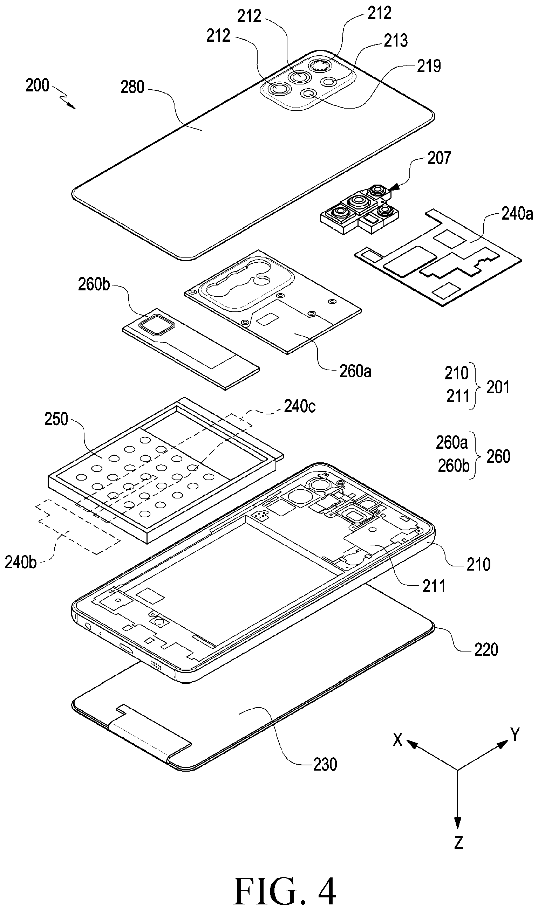

FIG. 3 is a front exploded perspective view illustrating the electronic device 200 according to an embodiment illustrated in the disclosure of FIG. 1. FIG. 4 is a rear exploded perspective view illustrating the electronic device 200 according to an embodiment illustrated in the disclosure of FIG. 1.

Referring to FIGS. 3 and 4, the electronic device 200 (e.g., the electronic device 100 in FIG. 1 or FIG. 2) may include a side surface structure 210, a first support member 211 (e.g., a bracket), a front surface plate 220 (e.g., the front surface plate 102 in FIG. 1), a display 230 (e.g., the display 101 in FIG. 1), one or more printed circuit boards (or substrate assemblies) 240a and 240b, a battery 250, a second support member 260 (e.g., a rear case), an antenna, a camera assembly 207, and a rear surface plate 280 (e.g., the rear surface plate 111 in FIG. 2). When including a plurality of printed circuit boards 240a and 240b, the electronic device 200 may include at least one flexible printed circuit board 240c to electrically connect different printed circuit boards. For example, the printed circuit boards 240a and 240b may include a first circuit board 240a positioned above the battery 250 and a second circuit board 240b positioned below the battery 250, and a flexible printed circuit board 240c may electrically connect the first circuit board 240a and the second circuit board 240b.

In an embodiment, in the electronic device 200, at least one of the components (e.g., the first support member 211 or the second support member 260) may be omitted, or other components may be additionally included. At least one of the components of the electronic device 200 may be the same as or similar to at least one of the components of the electronic device 100 of FIG. 1 or 2, and a redundant description thereof will be omitted below.

The first support member 211 may be provided in at least a partially planar form. In an embodiment, the first support member 211 may be disposed inside the electronic device 200 to be connected to the side surface structure 210 or may be integrated with the side surface structure 210. The first support member 211 may be made of, for example, a metal material and/or a non-metal (e.g., polymer) material. When at least partially being made of a metal material, a portion of the side surface structure 210 or the first support member 211 may serve as an antenna. The first support member 211 may include one surface to which the display 230 is coupled and the other surface to which the printed circuit boards 240a and 240b are coupled. A processor, memory, and/or an interface may be mounted on the printed circuit boards 240a and 240b. The processor may include, for example, one or more of a central processing unit, an application processor, a graphics processing unit, an image signal processor, a sensor hub processor, or a communication processor.

According to various embodiments, the first support member 211 and the side surface structure 210 may be combined to be referred to as a front case or a housing 201. According to an embodiment, the housing 201 may be generally understood as a structure for accommodating, protecting, or arranging printed circuit boards 240a and 240b, or a battery 250. In an embodiment, it may be understood that the housing 201 includes structures capable of being visually or tactfully recognized by a user in the exterior of the electronic device 200, such as the side surface structure 210, the front surface plate 220, and/or the rear surface plate 280. In an embodiment, the "front surface or rear surface of the housing 201" may refer to the first surface 110A in FIG. 1 or the second surface 110B in FIG. 2. In an embodiment, the first support member 211 may be disposed between the front surface plate 220 (e.g., the first surface 110A in FIG. 1) and the rear surface plate 280 (e.g., the second surface 110B in FIG. 2), and may serve as a structure on which electrical/electronic components, such as a printed circuit board 240 or a camera assembly 207, are disposed. In the detailed description below, the camera module may be exemplified as being generally configured to receive light incident through the second surface 110B in FIG. 2, but the camera module 105 of FIG. 1 may also be disposed inside an electronic device through the configuration of an embodiment described below.

The memory may include, for example, volatile memory or non-volatile memory.

The interface may include, for example, a high-definition multimedia interface (HDMI), a universal serial bus (USB) interface, an SD card interface, and/or an audio interface. For example, the interface may electrically or physically connect the electronic device 200 to an external electronic device, and include a USB connector, an SD card/MMC connector, or an audio connector.

The second support member 260 may include, for example, an upper support member 260a and a lower support member 260b. In an embodiment, the upper support member 260a may be disposed to surround the printed circuit board 240a or 240b (e.g., the first circuit board 240a) together with a portion of the first support member 211. For example, the upper support member 260a of the second support member 260 may be disposed to face the first support member 211 with the first circuit board 240a interposed therebetween. In an embodiment, the lower support member 260b of the second support member 260 may be disposed to face the first support member 211 with the second circuit board 240b interposed therebetween. Circuit devices implemented in the form of integrated circuit chips (e.g., a processor, a communication module, or memory) or various electrical/electronic components may be disposed on printed circuit boards 240a and 240b. According to an embodiment, the printed circuit boards 240a and 240b may be provided with an electromagnetic shielding environment from the second support member 260. In an embodiment, the lower support member 260b may be used as a structure on which electric/electronic components such as a speaker module and an interface (e.g., a USB connector, an SD card/MMC connector, or an audio connector) may be disposed. In an embodiment, electrical/electronic components, such as a speaker module and an interface (e.g., a USB connector, an SD card/MMC connector, or an audio connector), may be disposed on an additional printed circuit board (not illustrated). In this case, the lower support member 260b may be disposed to surround the additional printed circuit board together with the other portion of the first support member 211. A speaker module or an interface disposed on the additional printed circuit board (not illustrated) or the lower support member 260b may be disposed to correspond to the audio module 107 or the connector holes 108 and 109 in FIG. 1.

The battery 250 is a device for supplying power to at least one of the components of the electronic device 200 and may include, for example, a non-rechargeable primary battery, a rechargeable secondary battery, or a fuel cell. At least a portion of the battery 250 may be disposed on substantially the same plane as, for example, the printed circuit boards 240a and 240b. The battery 250 may be integrally disposed inside the electronic device 200, or may be disposed to be detachable from the electronic device 200.

Although not illustrated, the antenna may include a conductor pattern implemented on the surface of the second support member 260 through, for example, a laser direct structuring method. In an embodiment, the antenna may include a printed circuit pattern provided on the surface of a thin film, and the thin film-type antenna may be disposed between the rear surface plate 280 and the battery 250. The antenna may include, for example, a near-field communication (NFC) antenna, a wireless charging antenna, and/or a magnetic secure transmission (MST) antenna. The antenna may, for example, perform short-distance communication with an external device, or wirelessly transmit and receive power required for charging. In an embodiment, an antenna structure may be configured with a portion or a combination of the side surface structure 210 and/or the first support member 211.

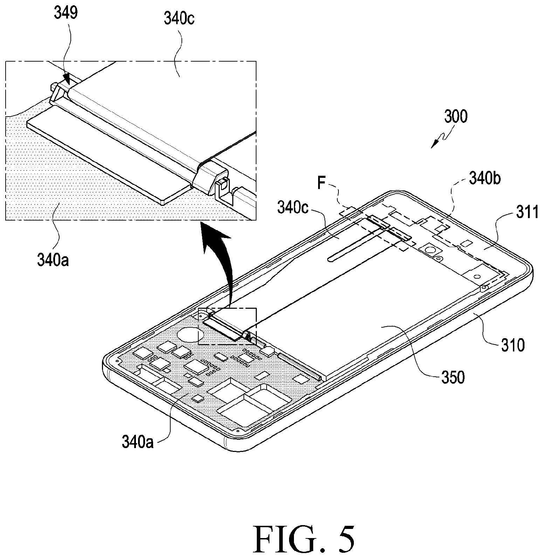

The camera assembly 207 may include at least one camera module (e.g., at least one of the camera modules 271, 200, 272, 273, and 274 in FIGS. 5). Inside the electronic device 200, the camera assembly 207 may receive at least some of light incident through optical holes or camera windows 212, 213, and 219. In an embodiment, the camera assembly 207 may be disposed on the first support member 211 at a position adjacent to the printed circuit board 240a or 240b. In an embodiment, the camera modules of the camera assembly 207 may be generally aligned with one of the camera windows 212, 213, and 219, and may be at least partially surrounded by the second support member 260 (e.g., the upper support member 260a).

It is noted that, in the following detailed description, the electronic devices 100 and 200 of the preceding embodiments may be referred to, and, for the components that may be easily understood through the preceding embodiments, similar reference numerals may be assigned or omitted, or a detailed description thereof may also be omitted.

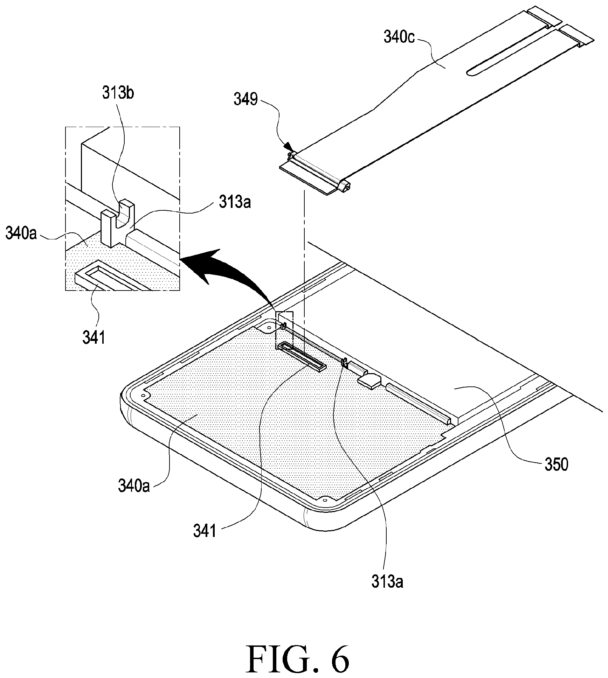

FIG. 5 is a perspective view illustrating a state after a fixing member 349 and/or a flexible printed circuit board 340c has been placed in an electronic device 300 according to an embodiment of the disclosure. FIG. 6 is a perspective view illustrating a state while the fixing member 349 and/or the flexible printed circuit board 340c is being placed in the electronic device 300 according to an embodiment of the disclosure.

Referring to FIGS. 5 and 6, the electronic device 300 (e.g., the electronic device 100 or 200 in FIGS. 1 to 4) may include a fixing member 349 configured to support or fix one end portion of the flexible printed circuit board 340c (e.g., the flexible printed circuit board 240c in FIG. 3 or FIG. 4) adjacent to the first circuit board 340a (e.g., the first circuit board 240a in FIG. 3 or FIG. 4). Although omitted in the drawings, the electronic device 300 may further include a second fixing member configured to support or fix the other end portion of the flexible printed circuit board 340c adjacent to the second circuit board 340b (e.g., the second circuit board 240b in FIG. 3 or FIG. 4) depending on the embodiment. The position where the second fixing member is placed is illustrated as "F" in FIG. 5. The second fixing member differs from the fixing member 349 in terms of its placement position and orientation, and it should be noted that its detailed description is omitted as it may be readily understood based on the configuration and placement of the fixing member 349.

According to an embodiment, the first support member 311 (e.g., the first support member 211 in FIG. 3 or FIG. 4) is disposed in an area surrounded by the side structure 310 (e.g., the side surface structure 210 in FIG. 3 or FIG. 4) and may have a flat shape at least in part. In an embodiment, the first support member 311 and the side surface structure 310 may be integrated and may include, at least in part, a metallic material, thereby functioning as an antenna that transmits and receives wireless signals. In an embodiment, on the other surface of the first support member 311, a battery 350 (e.g., the battery 250 in FIG. 3 or FIG. 4) may be disposed between the first circuit board 340a and the second circuit board 340b. The flexible printed circuit board 340c may have, for example, one end portion connected to the first circuit board 340a and the other end portion connected to the second circuit board 340b across the area where the battery 350 is disposed. For example, the flexible printed circuit board 340c may electrically connect the second circuit board 340b to the first circuit board 340a.

According to an embodiment, inside the electronic device 300 or on the other surface of the first support member 311, the flexible printed circuit board 340c may be generally arranged in a flat shape and partially arranged in a curved or bent shape. For example, in the portion placed over the battery 350, the flexible printed circuit board 340c may be disposed in a substantially flat form, while opposite end portions of the flexible printed circuit board 340c may be disposed in a curved or bent shape. In an embodiment, the flexible printed circuit board 340c may transmit power, various control signals, and/or data signals between the first circuit board 340a and the second circuit board 340b. In the illustrated embodiment, the flexible printed circuit board 340c connecting the first circuit board 340a and the second circuit board 340b is exemplified, but it should be noted that the embodiments of the present disclosure are not limited thereto. For example, the electronic device 300 may further include an additional flexible printed circuit board for connection with another component, such as an additional printed circuit board or a camera assembly (e.g., the camera assembly 207 in FIG. 3 or FIG. 4).

According to an embodiment, the electronic device 300 may include a fixing member 349 disposed at least at one of the opposite end portions of the flexible printed circuit board 340c. The fixing member 349 may, for example, support or maintain the shape or position of the flexible printed circuit board 340c in a standardized state. The term "standardized state" may be understood, for example, as a condition in which at least a portion of the flexible printed circuit board 340c maintains its assembled shape when no external force exceeding a predetermined intensity is applied. In an embodiment, the fixing member 349 may be configured to guide the position or shape of the flexible printed circuit board 240c or 340c. For example, the fixing member 349 may guide the flexible printed circuit board 240c or 340c to be disposed in an S shape or a zigzag shape. For example, the fixing member 349 may be described as a guide member. In various embodiments, supporting the flexible printed circuit board 240c or 340c with the fixing member 349 may include guiding the flexible printed circuit board 240c or 340c with the fixing member 349. For example, the fixing member 349 may guide the flexible printed circuit board 240c or 340c to maintain its position or shape by supporting at least a portion of the flexible printed circuit board 240c or 340c. For example, the fixing member 349 may support (e.g., guide) the flexible printed circuit board 240c or 340c to maintain a position or shape where it is bent two or more times. In this embodiment, the fixing member 349 may support or maintain the flexible printed circuit board 340c in a standardized state, at least at one end portion, thereby supporting or maintaining the flexible printed circuit board 340c in a state connected to the first circuit board 340a. In an embodiment, when an external force exceeding a predetermined intensity is applied, the fixing member 349 may allow partial deformation or movement of the flexible printed circuit board 340c while supporting or maintaining at least one end portion of the flexible printed circuit board 340c (e.g., the portion disposed on the first circuit board 340a) in a standardized state. In an embodiment, the fixing member 349 may substantially fix a portion of the flexible printed circuit board 340c onto the first support member 311.

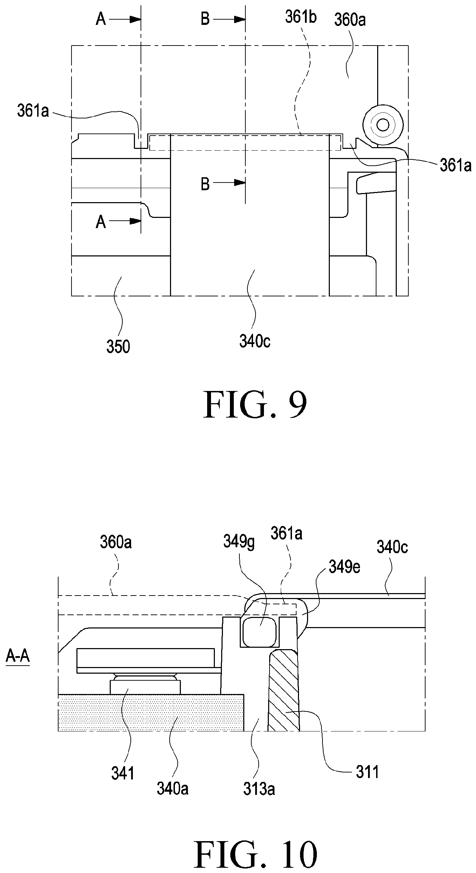

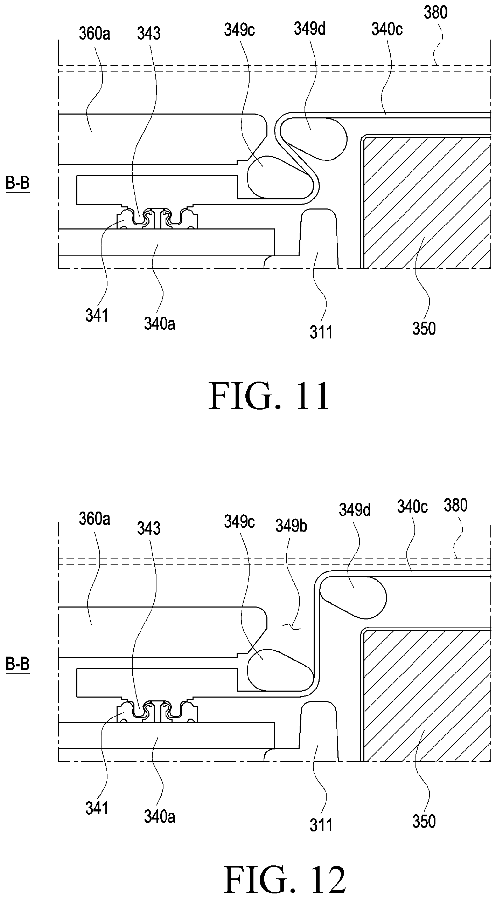

According to an embodiment, when an external force (e.g., tension) acts on the flexible printed circuit board 340c due to external environmental factors (e.g., external impacts or changes in temperature and humidity), the elasticity of the flexible printed circuit board 340c itself may act as a reactive force against the external force. When such an external force or reactive force act on the connection area (e.g., the connectors 341 and 343 in FIGS. 11 to 13) between the printed circuit board (e.g., the first circuit board 340a) and the flexible printed circuit board 340c, the flexible printed circuit board 340c may detach from the first circuit board 340a, or the connection structures, such as the connectors 341 and 343, may be damaged. In an embodiment, the fixing member 349 may support or maintain a portion of the flexible printed circuit board 340c while suppressing the external force or reactive force from being applied to the connection area between the first circuit board 340a and the flexible printed circuit board 340c. The support structure of the flexible printed circuit board 340c using the fixing member 349 will be further described with reference to FIGS. 9 to 13.

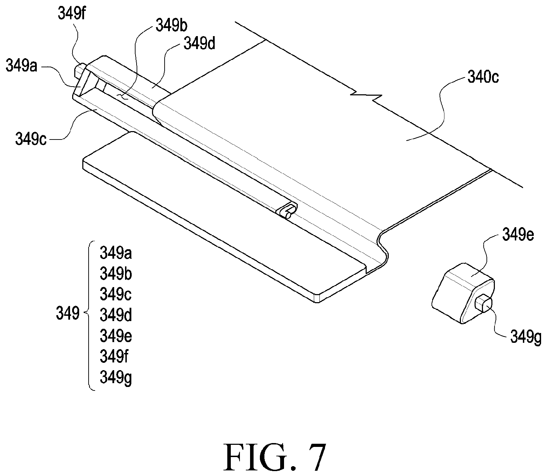

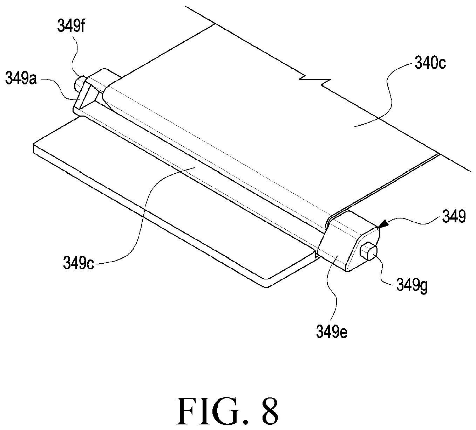

According to an embodiment, the electronic device 300 may include a pair of support ribs 313a. The support ribs 313a may protrude, for example, from one surface of the first support member 311 in the area between the first circuit board 340a and the battery 350. In an embodiment, the support ribs 313a may be disposed to face each other, and the fixing member 349 may be disposed between the support ribs 313a. For example, in the area between the first circuit board 340a and the battery 350, the support ribs 313a may serve as structures for placing or fixing the fixing member 349. In an embodiment, the electronic device 300 may include accommodating recesses 313b formed respectively on the support ribs 313a. The electronic device 300 and/or the fixing member 349 may include support protrusions (e.g., the support protrusions 349f and 349g in FIGS. 7 or FIG. 8) corresponding to the accommodating recesses 313b. The fixing member 349 may be disposed between the support ribs 313a with the support protrusions 349f and 349g respectively accommodated in any of the accommodating recesses 313b. The support ribs 313a and/or the fixing member 349 are disposed adjacent to the connector 341 of the first circuit board 340a, and the flexible printed circuit board 340c may be partially disposed on the first support member 311 by the support ribs 313a and/or the fixing member 349 and may be connected to the connector 341 of the first circuit board 340a.

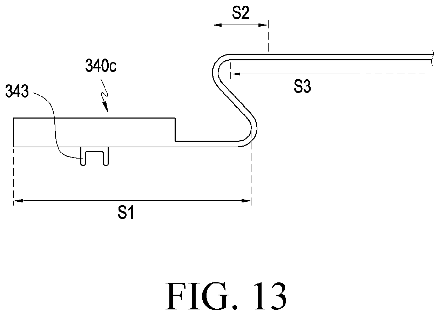

In the following detailed description, FIG. 13 may be additionally referenced, even if the flexible printed circuit board 340c is not explicitly mentioned. FIG. 13 is a view illustrating the flexible printed circuit board 340c of the electronic device 300 according to an embodiment of the disclosure, in which the shape of the flexible printed circuit board 340c disposed on the first support member 311 is illustrated. Referring to FIG. 13, the flexible printed circuit board 340c may include, for example, a connector 343 (e.g., a male connector) provided at one end and, for convenience of explanation, the flexible printed circuit board may be divided into a first section S1, a second section S2, and a third section S3. The first section S1 may refer to, for example, the section from the end portion where the connector 343 is disposed to the fixing member 349. In an embodiment, the first section S1 may be understood as one end portion of the flexible printed circuit board 340c that is standardized by the fixing member 349. In an embodiment, the second section S2 is a portion substantially supported by the fixing member 349 and may be disposed an S shape or a zigzag shape. In an embodiment, when an external force is applied, the shape of the second section S2 may be deformed or moved differently from the shape illustrated in FIG. 13. This will be further described with reference to FIGS. 11 and 12. In an embodiment, the third section S3 may be understood as the section extending from the fixing member 349 and substantially disposed on the battery 350. In an embodiment, the third section S3 may refer to the portion of the flexible printed circuit board 340c extending from the fixing member 349 to the other end portion of the flexible printed circuit board. In an embodiment, a portion of the second section S2 may overlap the first section S1, and another portion of the second section S2 may overlap the third section S3. It should be noted that dividing the flexible printed circuit board 340c into the first section S1, the second section S2, and the third section S3 is solely for the convenience of explanation and is not intended to limit the embodiments of the disclosure. For example, the first section S1, the second section S2, and the third section S3 of the flexible printed circuit board 340c may be differently defined depending on the embodiment, the assembled shape, and/or the deformed shape caused by an external force or the elasticity of the flexible printed circuit board itself.

FIG. 7 is a perspective view illustrating the state while the fixing member 349 and the flexible printed circuit board 340c are being placed in an electronic device (e.g., the electronic device 100, 200, or 300 in FIGS. 1 to 5) according to an embodiment of the disclosure. FIG. 8 is a perspective view illustrating a state after the fixing member 349 and/or the flexible printed circuit board 340c has been placed in the electronic device 300 according to an embodiment of the disclosure.

Referring to FIGS. 7, 8, and 13, the fixing member 349 may include a slit 349b extending in one direction and a pair of rods 349c and 349d defining the slit 349b. For example, the pair of rods 349c and 349d may extend parallel to each other in one direction, and the slit 349b may be defined between the pair of rods 349c and 349d. In an embodiment, a portion of the flexible printed circuit board 340c may be disposed through the slit 349b and positioned inside the electronic device 300 in an S shape or a zigzag shape defined by the slit 349b and/or the fixing member 349. In an embodiment, of the rods 349c and 349d, the first rod 349c may be disposed across the flexible printed circuit board 340c on one surface of the flexible printed circuit board, while the second rod 349d may be disposed across the flexible printed circuit board 340c on the other surface of the flexible printed circuit board. Two adjacent portions of the flexible printed circuit board 340c may be disposed to partially wrap around the first rod 349c and the second rod 349d, thereby forming an S shape or a zigzag shape. For example, when the portion of the flexible printed circuit board 340c wrapping around the first rod 349c is defined as having a positive (+) curvature radius, the portion of the flexible printed circuit board 340c wrapping around the second rod 349d may be understood to have a negative (-) curvature radius.

According to an embodiment, the fixing member 349 may further include a head 349a, a cap 349e, and/or support protrusions 349f and 349g. The head 349a may be provided at, for example, one end of the first rod 349c and/or the second rod 349d, and the first rod 349c and the second rod 349d may extend substantially parallel to each other from the head 349a. The cap 349e may be provided at the other ends of the first rod 349c and the second rod 349d to couple or connect one ends of the first rod 349c and the second rod 349d. As a result, the slit 349b may be substantially surrounded by the head 349a, the cap 349e, the first rod 349c, and the second rod 349d, and may extend in the direction in which the first rod 349c and the second rod 349d extend. **In** an embodiment, of the support protrusions 349f and 349g, the first support protrusion 349f may protrude from the head 349a in the direction in which the slit 349b extends. For example, at a position adjacent to the one end of the slit 349b, the first support protrusion 349f may protrude outward from the fixing member 349. **In an** embodiment, of the support protrusions 349f and 349g, the second support protrusion 349g may protrude from the cap 349e in the direction in which the slit 349b extends. For example, at a position adjacent to the other end of the slit 349b, the second support protrusion 349g may protrude outward from the fixing member 349.

According to an embodiment, before the cap 349e is coupled, the flexible printed circuit board 340c may be disposed inside the slit 349b. For example, the gap between the first rod 349c and the second rod 349d, or the width of the slit 349b, may be substantially larger than the thickness of the flexible printed circuit board 340c. In an embodiment, the first rod 349c may be disposed on one surface of the flexible printed circuit board 340c to support or maintain the one end portion of the flexible printed circuit board 340c in a standardized state. As will be described later, depending on the embodiment, the first rod 349c may press against one surface of the flexible printed circuit board 340c to stably maintain the connected state between the flexible printed circuit board 340c and the first circuit board 340a. **In** an embodiment, the second rod 349d may be disposed on the other surface of the flexible printed circuit board 340c and may be moved or deformed in response to an external force acting on the flexible printed circuit board 340c. For example, the second rod 349d may be more flexible than the first rod 349c. For example, the second rod 349d may allow deformation or movement of the flexible printed circuit board 340c in response to an external force, thereby suppressing or alleviating the application of the external force to the one end portion of the flexible printed circuit board 340c. This may suppress the disconnection or damage of the connection structure between the flexible printed circuit board 340c and the first circuit board 340a caused by changes in temperature or humidity, or by impacts.

According to an embodiment, the first support protrusion 349f may be accommodated in one of the accommodating recesses (e.g., the accommodating recesses 313b in FIG. 6), and the second support protrusion 349g may be accommodated in another one of the accommodating recesses 313b. For example, the fixing member 349 may be disposed between the support ribs 313a with the support protrusions 349f and 349g accommodated in any of the accommodating recesses 313b. As will be described later, by disposing the second support member (e.g., the upper support member 260a in FIG. 3), the support protrusions 349f and 349g may be restrained or maintained in the state accommodated in one of the accommodating recesses 313b.

FIG. 9 is a view illustrating the state after the fixing member (e.g., the fixing member 349 in FIG. 7 or FIG. 8) and/or the flexible printed circuit board 340c in an electronic device (e.g., the electronic device 100, 200, or 300 in FIGS. 1 to 5) according to an embodiment of the disclosure. FIG. 10 is a view illustrating a partial cross-sectional view of the electronic device 300 according to an embodiment of the disclosure taken along line A-A of FIG. 9.

Referring to FIGS. 9 and 10, by disposing the second support member 360a, the fixing member 349 may be substantially fixed on the first support member 311. The second support member 360a may have a substantially flat shape corresponding to the first circuit board 340a and may include support pieces 361a extending from respective edges on one side. In an embodiment, by disposing the support pieces 361a, the second support member 360a may include a notch area or accommodating area 361b defined between the support pieces 361a. When the second support member 360a is disposed to face the first support member 311 with the first circuit board 340a interposed therebetween, the support pieces 361a may be disposed to correspond to any of the accommodating recesses 313b or the support ribs 313a. For example, the support pieces 361a may maintain or restrain the support protrusions 349f and 349g in a state accommodated within the accommodating recesses 313b. The fixing member 349 may be disposed to substantially correspond to the accommodating area 361b and may provide a space that allows the second rod 349d to be moved or deformed.

FIG. 11 is a view illustrating a partial cross-sectional view of an electronic device (e.g., the electronic devices 100, 200, or 300 illustrated in FIGS. 1 to 5) along line B-B in FIG. 9, according to an embodiment of the disclosure. FIG. 12 is a view illustrating a partial cross-sectional view of the electronic device 300 taken along line B-B in FIG. 9, according to an embodiment of the disclosure, in which a deformed state of a portion of the fixing member 349 and/or the flexible printed circuit board 340c is illustrated.

Referring to FIGS. 11 and 12, inside the electronic device 300, the first rod 349c may be disposed, at least partially, within the space between the second rod 349d and the first circuit board 340a, or the space between the second rod 349d and the first support member 311. For example, the first rod 349c may be disposed closer to the first circuit board 340a or the first support member 311 than the second rod 349d. The one end portion of the flexible printed circuit board 340c, such as the first section S1 in FIG. 13, may be disposed, at least partially, between the first rod 349c and the first circuit board 340a (or between the first rod 349c and the first support member 311). In an embodiment, a portion of the flexible printed circuit board 340c disposed in an S shape or a zigzag shape (e.g., the second section S2 in FIG. 13) may be disposed around the first rod 349c or the second rod 349d while extending from the first section S1 through the slit 349b. The third section S3 of the flexible printed circuit board 340c may extend from the second section S2 to be substantially disposed on the battery 350. For example, the third section S3 may be disposed substantially between the rear surface plate 380 (e.g., the rear plate 280 in FIG. 3 or FIG. 4) of the electronic device 300 and the first support member 311, or between the rear surface plate 380 and the battery 350. The third section S3 may, for example, extend or be disposed across the area where the battery 350 is disposed and may be electrically connected to the second circuit board (e.g., the second circuit board 240b or 340b in FIGS. 3 to 5).

According to an embodiment, since the first rod 349c supports the flexible printed circuit board 340c and the second section S2 is disposed in an S shape, the first section S1 illustrated in FIG. 11 may have a tendency to pivot counterclockwise around the first rod 349c. For example, as the shape of the flexible printed circuit board 340c resulting from the arrangement of the fixing member 349 is combined with the inherent elasticity of the flexible printed circuit board 340c, the one end portion of the flexible printed circuit board 340c may be pressed toward the first circuit board 340a. This may stably maintain the connection state between the flexible printed circuit board 340c and the first circuit board 340a.

According to an embodiment, when an external force EF is applied to the flexible printed circuit board 340c, the second rod 349d may be deformed or moved toward or away from the first rod 349c, thereby allowing a portion of the flexible printed circuit board 340c (e.g., the second section S2) to be moved or deformed. The description "deformation of the flexible printed circuit board 340c" may be understood as a change in the curvature radius of the flexible printed circuit board 340c in the second section S2. For example, a substantial change in the curvature radius of the flexible printed circuit board 340c may offset or absorb the external force EF applied to the flexible printed circuit board 340c. As a result, the external force EF may not substantially be applied to the connection area (e.g., the connectors 341 and 343) between the flexible printed circuit board 340c and the first circuit board 340a. For example, by disposing the fixing member 349, the connection state between the flexible printed circuit board 340c and the first circuit board 340a may be stably maintained, and the connectors 341 and 343 may be restricted from being separated or damaged due to the external force EF.

As described above, the fixing member 349 may stabilize the connection state between the flexible printed circuit board 240c or 340c and the first circuit board 240a or 340a by standardizing the flexible printed circuit board 240c or 340c within the electronic device 100, 200, or 300, and may suppress the external force applied to the flexible printed circuit board 240c or 340c from acting on the one end portion of the flexible printed circuit board 240c or 340c. As a result, the flexible printed circuit board 240c or 340c may be protected from damage without being separated from the first circuit board 240a or 340a even when an external force is applied.

The effects that are capable of being obtained by the disclosure are not limited to those described above, and other effects not described above may be clearly understood by a person ordinarily skilled in the art to which the disclosure belongs based on the following description.

As described above, according to an embodiment of the disclosure, an electronic device (e.g., the electronic device 100, 200, or 300 in FIGS. 1 to 5) may include a first support member (e.g., the first support member 211 or 311 in FIGS. 3 to 5) having a flat shape, a first circuit board (e.g., the first circuit board 240a or 340a in FIGS. 3 to 5) disposed on one surface of the first support member, a fixing member (e.g., the fixing member 349 in FIGS. 5 to 8 or 11 to 12) disposed on the first support member at a position adjacent to the first circuit board and including a slit (e.g., the slit 349b in FIG. 7) extending in one direction, and a flexible printed circuit board (FPCB) (e.g., the flexible printed circuit board 240c or 340c in FIGS. 3 to 12) disposed at least partially in an S shape or a zigzag shape through the slit and having one end portion connected to the first circuit board. In an embodiment, the fixing member may be configured to support the flexible printed circuit board to maintain a position or shape of the one end portion of the flexible printed circuit board relative to the first circuit board.

According to an embodiment, the electronic device may further include a second circuit board (e.g., the second circuit board 240b or 340b in FIGS. 3 to 5) disposed on the one surface of the first support member, and a battery (e.g., the battery 250 or 350 in FIGS. 3 to 5) disposed in an area between the first circuit board and the second circuit board on the one surface of the first support member. In an embodiment, the flexible printed circuit board may be disposed across an area where the battery is disposed to electrically connect the second circuit board to the first circuit board.

According to an embodiment, the fixing member may be at least partially disposed in an area between the first circuit board and the battery.

According to an embodiment, the fixing member may include a head (e.g., the head 349a in FIG. 7 or FIG. 8), a first rod (e.g., the first rod 349c in FIG. 7 or FIG. 8) and a second rod (e.g., the second rod 349d in FIG. 7 or FIG. 8) extending parallel to each other from the head, and a cap (e.g., the cap 349e in FIG. 7 or FIG. 8) that connects or joins end portions of the first rod and the second rod. In an embodiment, the slit may be formed between the first rod and the second rod.

According to an embodiment, the second rod may be configured to be at least partially deformed in a direction closer to or away from the first rod in response to an external force applied to the flexible printed circuit board or an elastic force of the flexible printed circuit board.

According to an embodiment, the first rod may be disposed closer to the first circuit board or the first support member than the second rod.

According to an embodiment, a portion of the flexible printed circuit board may be disposed between the first rod and the first circuit board, or between the first rod and the first support member.

According to an embodiment, the first rod may be configured to press the flexible printed circuit board in a direction that brings one end portion of the flexible printed circuit board closer to the first circuit board.

According to an embodiment, the electronic device may further include a first support protrusion (e.g., the first support protrusion 349f in FIG. 7 or FIG. 8) protruding from the head along a direction in which the slit extends, a second support protrusion (e.g., the second support protrusion 349g in FIG. 7 or FIG. 8) protruding from the cap along the direction in which the slit extends, a pair of support ribs (e.g., the support ribs 313a in FIG. 6) protruding from the one surface of the first support member and disposed to face each other, and accommodating recesses (e.g., the accommodating recesses 313b in FIG. 6) provided in the support ribs, respectively. In an embodiment, the fixing member may be disposed between the support ribs with the first support protrusion and the second support protrusion being accommodated in the accommodating recesses, respectively.

According to an embodiment, the electronic device may further include a second support member (e.g., the upper support member 260a in FIGS. 3 and 4 or the second support member 360a in FIGS. 9 to 12) coupled to face the first support member with at least a portion of the first circuit board interposed therebetween. In an embodiment, the second support member may be configured to restrain the first support protrusion and the second support protrusion within the accommodating recesses.

According to an embodiment, the second support member may further include support pieces (e.g., the support pieces 361a in FIG. 9) each extending from one edge and disposed to correspond to one of the support ribs, and an accommodating area (e.g., the accommodating area 361b in FIG. 9) disposed between the support pieces to correspond to the fixing member.

According to an embodiment, the electronic device may further include a rear surface plate (e.g., the rear surface plate 280 or 380 in FIG. 3, FIG. 4, or FIG. 11) disposed to face one surface of the first support member with the first circuit board and the fixing member interposed therebetween. In an embodiment, the flexible printed circuit board may be sequentially extended or disposed from the one end portion connected to the first circuit board through a space between the fixing member and the first support member, the slit, and a space between the fixing member and the rear surface plate (see FIG. 11 or FIG. 12).

According to an embodiment, the electronic device may further include a display (e.g., the display 101 or 230 in FIG. 1 or FIG. 3) disposed on the other surface of the first support member.

According to an embodiment of the disclosure, an electronic device (e.g., the electronic device 100, 200, or 300 in FIGS. 1 to 5) may include a first support member (e.g., the first support member 211 or 311 in FIGS. 3 to 5) having a flat shape, a first circuit board (e.g., the first circuit board 240a or 340a of FIGS. 3 to 5) disposed at a first position (e.g., the upper side of the battery in FIG. 3) on an one surface of the first support member, a second circuit board (e.g., the second circuit board 240b or 340b in FIGS. 3 to 5) disposed at a second position (e.g., the lower side of the battery in FIG. 3) different from the first position on the one surface of the first support member, a fixing member (e.g., the fixing member 349 in FIGS. 5 to 8 or 11 to 12) disposed on the first support member at a position adjacent to the first circuit board and including a slit (e.g., the slit 349b in FIG. 7) extending in one direction, and a flexible printed circuit board (e.g., the flexible printed circuit board 240c or 340c in FIGS. 3 to 12) disposed at least partially in an S shape or a zigzag shape through the slit, the flexible printed circuit board being connected at one end portion to the first circuit board and electrically connecting the second circuit board to the first circuit board. In an embodiment, the fixing member may include a first rod (e.g., the first rod 349c in FIG. 7 or FIG. 8) disposed across the flexible printed circuit board to guide the flexible printed circuit board and thereby maintain a position or shape of the one end portion of the flexible printed circuit board relative to the first circuit board, and a second rod (e.g., the second rod 349d in FIG. 7 or FIG. 8) disposed across the flexible printed circuit board at a position farther from the first circuit board or the first support member than the first rod. In an embodiment, the slit may be formed between the first rod and the second rod.

According to an embodiment, the second rod may be configured to be at least partially deformed in a direction closer to or away from the first rod in response to an external force applied to the flexible printed circuit board or an elastic force of the flexible printed circuit board.

According to an embodiment, a portion of the flexible printed circuit board may be disposed between the first rod and the first circuit board, or between the first rod and the first support member.

According to an embodiment, the fixing member may further include a head (e.g., the head 349a in FIG. 7 or FIG. 8), and a cap (e.g., the cap 349e in FIG. 7 or FIG. 8) that connects or joins end portions of the first rod and the second rod. In an embodiment, the first rod and the second rod may extend parallel to each other from the head.

According to an embodiment, the electronic device may further include a first support protrusion (e.g., the first support protrusion 349f in FIG. 7 or FIG. 8) protruding from the head along a direction in which the slit extends, a second support protrusion (e.g., the second support protrusion 349g in FIG. 7 or FIG. 8) protruding from the cap along the direction in which the slit extends, a pair of support ribs (e.g., the support ribs 313a in FIG. 6) protruding from the one surface of the first support member and disposed to face each other, and accommodating recesses (e.g., the accommodating recesses 313b in FIG. 6) provided in the support ribs, respectively. In an embodiment, the fixing member may be disposed between the support ribs with the first support protrusion and the second support protrusion being accommodated in the accommodating recesses, respectively.

According to an embodiment, the electronic device may further include a second support member (e.g., the upper support member 260a in FIGS. 3 and 4 or the second support member 360a in FIGS. 9 to 12) coupled to face the first support member with at least a portion of the first circuit board interposed therebetween. In an embodiment, the second support member may be configured to restrain the first support protrusion and the second support protrusion within the accommodating recesses.

According to an embodiment, the electronic device may further include a second fixing member disposed on the first support member at a position adjacent to the second circuit board (e.g., the position indicated by "F" in FIG. 5) and including a second slit. In an embodiment, the other end portion of the flexible printed circuit board may be disposed in an S shape or a zigzag shape through the second slit and connected to the second circuit board.

Although an embodiment of the disclosure has been illustrated and described, it should be appreciated that the embodiment is not intended to limit the disclosure, but is provided for the sake of illustration. It will be apparent to those skilled in the art that various changes may be made to the form and details of the disclosure without departing from the overall perspective of the disclosure including the appended claims and equivalents thereof.

## Claims

1. An electronic device (100; 200; 300) comprising:
a first support member (211; 311) having a flat shape;
a first circuit board (240a; 340a) disposed on one surface of the first support member;
a fixing member (349) disposed on the first support member at a position adjacent to the first circuit board and comprising a slit (349b) extending in one direction; and
a flexible printed circuit board (FPCB) (240c; 340c) disposed at least partially in an S-shape or a zigzag shape through the slit and having one end portion connected to the first circuit board,
wherein the fixing member is configured to support the flexible printed circuit board to maintain a position or shape of the one end portion of the flexible printed circuit board relative to the first circuit board.

2. The electronic device of claim 1, further comprising:
a second circuit board (240b; 340b) disposed on the one surface of the first support member; and
a battery (250; 350) disposed in an area between the first circuit board and the second circuit board on the one surface of the first support member,
wherein the flexible printed circuit board is disposed across an area where the battery is disposed to electrically connect the second circuit board to the first circuit board.

3. The electronic device of claim 2, wherein the fixing member is at least partially disposed in an area between the first circuit board and the battery.

4. The electronic device of one of claims 1 to 3, wherein the fixing member comprises:
a head (349a);
a first rod (349c) and a second rod (349d) extending parallel to each other from the head; and
a cap (349e) that connects or joins end portions of the first rod and the second rod,
wherein the slit is formed between the first rod and the second rod.

5. The electronic device of claim 4, wherein the second rod is configured to be at least partially deformed in a direction closer to or away from the first rod in response to an external force applied to the flexible printed circuit board or an elastic force of the flexible printed circuit board.

6. The electronic device of one of claims 4 to 5, wherein the first rod is disposed closer to the first circuit board or the first support member than the second rod.

7. The electronic device of one of claims 4 to 6, wherein a portion of the flexible printed circuit board is disposed between the first rod and the first circuit board, or between the first rod and the first support member.

8. The electronic device of claim 7, wherein the first rod is configured to press the flexible printed circuit board in a direction that brings one end portion of the flexible printed circuit board closer to the first circuit board.

9. The electronic device of one of claims 4 to 8, further comprising:
a first support protrusion (349f) protruding from the head along a direction in which the slit extends;
a second support protrusion (349g) protruding from the cap along the direction in which the slit extends;
a pair of support ribs (313a) protruding from the one surface of the first support member and disposed to face each other; and
accommodating recesses (313b) provided in the support ribs, respectively,
wherein the fixing member is disposed between the support ribs with the first support protrusion and the second support protrusion being accommodated in the accommodating recesses, respectively.

10. The electronic device of claim 9, further comprising:
a second support member (260, 260a; 360a) coupled to face the first support member with at least a portion of the first circuit board interposed therebetween,
wherein the second support member is configured to restrain the first support protrusion and the second support protrusion within the accommodating recesses.

11. The electronic device of one of claims 9 to 10, wherein the second support member further comprises:
support pieces (361a) each extending from one edge and disposed to correspond to one of the support ribs; and
an accommodating area (361b) disposed between the support pieces to correspond to the fixing member.

12. The electronic device of one of claims 1 to 11, further comprising:
a rear surface plate (280; 380) disposed to face one surface of the first support member with the first circuit board and the fixing member interposed therebetween,
wherein the flexible printed circuit board is sequentially extended or disposed from the one end portion connected to the first circuit board through a space between the fixing member and the first support member, the slit, and a space between the fixing member and the rear surface plate.

13. The electronic device of one of claims 1 to 12, further comprising:
a display (101; 230) disposed on another surface of the first support member.

14. The electronic device of one of claims 1 to 13, further comprising:
a second circuit board (240b; 340b) disposed at a second position different from the first position on the one surface of the first support member,
wherein the flexible printed circuit board electrically connects the second circuit board to the first circuit board,
wherein the fixing member comprises:
a first rod (349c) disposed across the flexible printed circuit board to guide the flexible printed circuit board and thereby maintain a position or shape of the one end portion of the flexible printed circuit board relative to the first circuit board; and
a second rod (349d) disposed across the flexible printed circuit board at a position farther from the first circuit board or the first support member than the first rod, and
wherein the slit is formed between the first rod and the second rod.

15. The electronic device of claim 14, further comprising:
a second fixing member disposed on the first support member at a position (F) adjacent to the second circuit board and comprising a second slit,
wherein another end portion of the flexible printed circuit board is arranged in an S shape or a zigzag shape through the second slit and connected to the second circuit board.
